Europäisches Patentamt

European Patent Office

Office européen des brevets

(19)

(11) Veröffentlichungsnummer: **0 005 166**
**B1**

(12) **EUROPÄISCHE PATENTSCHRIFT**

(45) Veröffentlichungstag der Patentschrift: **26.01.83**

(51) Int. Cl.³: **H 01 L 21/31**

(21) Anmeldenummer: **79100950.9**

(22) Anmeldetag: **29.03.79**

(54) **Verfahren zur Herstellung von Halbleiteranordnungen mit isolierten Bereichen aus polykristallinem Silicium und danach hergestellte Halbleiteranordnungen.**

(30) Priorität: **01.05.78 US 901901**

(43) Veröffentlichungstag der Anmeldung:
**14.11.79 Patentblatt 79/23**

(45) Bekanntmachung des Hinweises auf die Patenterteilung:
**26.01.83 Patentblatt 83/4**

(84) Benannte Vertragsstaaten:
**DE FR GB**

(56) Entgegenhaltungen:
**DE - A - 2 705 611**
**GB - A - 1 326 947**
**US - A - 3 986 896**

(73) Patentinhaber: **International Business Machines Corporation**
**Armonk, N.Y. 10504 (US)**

(72) Erfinder: **Garbarino, Paul Louis**
**187 Barlow Mt.Rd.**
**Ridgefield Connecticut 06877 (US)**
Erfinder: **Revitz, Martin**
**73 Mandalay Drive**
**Poughkeepsie, N.Y. 12603 (US)**
Erfinder: **Shepard, Joseph Francis**
**Country Club Road**
**Hopewell Junction, N.Y. 12533 (US)**

(74) Vertreter: **Gaugel, Heinz, Dipl.-Ing.**
**Schönaicher Strasse 220**
**D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

Verfahren zur Herstellung von Halbleiteranordnungen mit isolierten Bereichen aus
polykristallinem Silicium und danach hergestellte Halbleiteranordnungen

Die Erfindung liegt auf dem Gebiet der Bauelemente vom Feldeffekttyp enthaltenden Halbleiteranordnungen, wie sie beispielsweise von sog. Ladungskopplungsanordnungen (CCD) und Feldeffekttransistoren (FET) dargestellt werden, und befaßt sich im engeren Sinne mit der Isolation von verschiedenen Leitungsebenen.

Bei Halbleiteranordnungen, für die die erwähnten Ladungskopplungsanordnungen typisch sind, ist es durchaus üblich, mehrere Leiterzugebenen für die jeweiligen elektrischen Verbindungen vorzusehen. Statt der Benutzung von metallischen Leiterzügen ist es mehr und mehr wünschenswert geworden, polykristallines Silicium (im folgenden auch Polysilicium genannt) zu benutzen. Für eine einwandfreie Funktion der letztlich hergestellten Halbleiterschaltung ist es jedoch von Wichtigkeit, diese verschiedenen, z.B. zwei Polysilicium-Verbindungsebenen zuverlässig voneinander zu isolieren. Kritische Isolationsprobleme wurden insbesondere im Bereich der Seitenflächen benachbarter Polysilicium-Leitungen festgestellt. Als eine Fehlerursache kommen dafür sog. Nadellöcher bzw. Poren im dielektrischen Material in Frage. Eine weitere Fehlerursache liegt jedoch zweifellos darin, daß die Isolation der Seitenflächen durch einen von der Deckflächenisolation her bestehenden Überhang erschwert wird. Ein solcher Überhang entsteht in der Regel durch ein Unterätzen bzw. übermäßiges Ätzen des Polysiliciums, wenn die dielektrische Deckflächenbeschichtung als Maskenschicht dient. Das Ausmaß eines solchen Überhangs ist abhängig von der Ätzwirksamkeit des Polysiliciums; um jedoch in jedem Fall sicherzustellen, daß bei der Ausbildung des Polysiliciummusters die Polysiliciumlage bis auf das Gateoxid zuverlässig durchgeätzt bzw. durchgetrennt wird, ist die Entstehung eines solchen Überhangs nahezu unvermeidbar und muß stets berücksichtigt werden. Für die auf dem Polysilicium schließlich aufzubringende Isolierung, insbesondere die seitliche Isolierung, folgen daraus erhebliche und unvermeidbare Schwierigkeiten.

Zur Vermeidung darartiger Isolationsmängel, z.B. von Nadellöchern bzw. um dielektrische Durchschläge zu verhindern, ist est bereits bekannt, die Dicke der die erste Polysiliciumlage bedeckenden Isolierschicht, einschließlich der kritischen Seitenflächen, zu vergrößern. Bei Einsatz konventioneller Verfahren wird dadurch jedoch auch die Dicke der Gatelsolierschicht (gewöhnlich also des Gateoxids) vergrößert. In Halbleiteranordnungen mit Feldeffektelementen soll diese Gateoxidschicht jedoch gewöhnlich sehr dünn gehalten werden. Eine Vergrößerung der Dicke wirkt sich zwangsläufig nachteilig auf die Bauelementeigenschaften aus.

Die Erfindung, wie sie in den Ansprüchen gekennzeichnet ist, löst in dem geschilderten Zusammenhang die Aufgabe, eine verbesserte Isolation derartiger Bereiche aus polykristallinem Silicium zu ermöglichen, was insbesondere im Hinblick auf mehrlagige Polysilicium-Verbindungsebenen erwünscht ist. Konkreter Ansatzpunkt für diese Aufgabe ist im Rahmen der Erfindung die Beseitigung oder doch wenigstens weitgehende Reduzierung des oben geschilderten und von der Formätzung der Polysiliciumbereiche vorgefundenen Überhangs der dielektrischen Deckflächenschicht. Die anzugebenden Maßnahmen sollen sich dabei möglichst nachteilsfrei in den Verfahrensablauf für die Herstellung derartiger Anordnungen einfügen lassen.

Aus der GB—A—1326947 ist ein Verfahren zur Herstellung eines Silicium-Gate Feldeffekttransistors bekannt, nach dem eine Kontaktschicht über einer verschiedene Ebenen aufweisenden Oberfläche aufzubringen ist. Um Riße an den scharfen Kanten zu vermeiden, wird eine dazwischenliegende Glasschicht aufgebracht und einer Wärmebehandlung unterworfen, wobei glatte abgerundete Kanten erhalten werden.

Im folgenden wird die Erfindung anhand von lediglich einen Ausführungsweg darstellenden Zeichnungen näher erläutert. Es zeigen:

Fig. 1 eine schematische Querschnittsdarstellung einer in konventioneller Weise hergestellten Halbleiterstruktur;

Fign. 2 bis 4 entsprechende Querschnittsdarstellungen, wie sie sich in verschiedenen Verfahrensstufen im Rahmen dieser Erfindung ergeben.

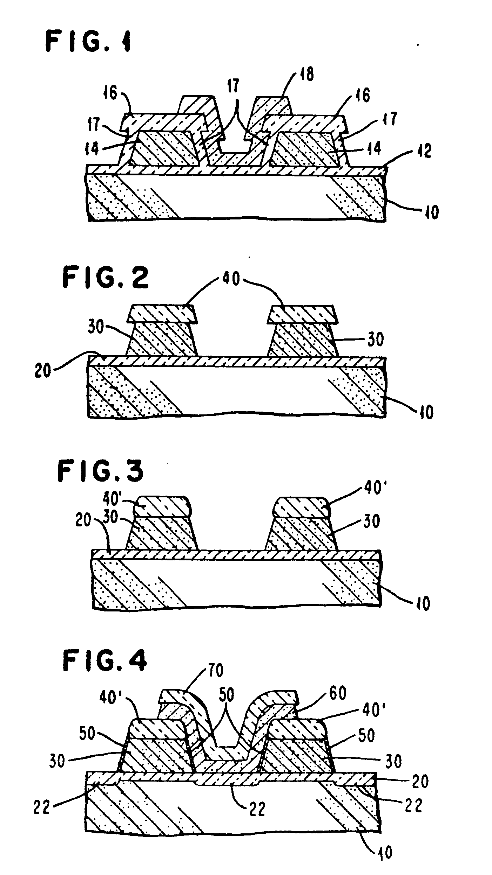

Der in Fig. 1 gezeigte Ausschnitt aus einer konventionellen Halbleiterstruktur zeigt ein einkristallines Siliciumsubstrat 10 als Unterlage für die übrige Struktur. Dieses Substrat 10 kann P oder N dotiert sein, je nachdem ob die Herstellung von N-Kanal oder P-Kanal Feldeffektelementen erfolgen soll. In dem Substrat können darüber hinaus weitere Dotierungsgebiete mittels Diffusion oder Ionenimplantation für besondere Anwendungsfälle vorgesehen werden, z.B. für Ladungskopplungsanordnungen mit sog. vergrabenen Kanälen, komplementäre Feldeffektelemente usw.

Eine gewöhnlich aus thermischem Siliciumdioxid bestehende Schicht 12 bedeckt die Oberfläche des Substrats 10. Diese Schicht 12 wird gewöhnlich als Gate-Oxid angesprochen, da sie als Dielektrikum zwischen der Gate-Elektrode und dem dazu benachbarten Kanalbereich im darunter liegenden Substrat dient. Die Gate-Oxidschicht 12 wird in der Form gebildet, daß man die Oberfläche des Siliciumsubstrats 10 bei erhöhter Temperatur einem Sauerstoff enthaltenden Dampf aussetzt, daß die Siliciumatome in Siliciumdioxyd umgesetzt werden.

Dieses dünne thermische Oxid wird dann mit einer durchgehenden Polysiliciumschicht 14 bedeckt. Auf die Polysiliciumschicht 14 wird dann eine durch chemischen Niederschlag aus der Gasphase (CVD) gebildete Oxidschicht 16 aufgebracht, die ihrerseits durch eine Photolackschicht abgedeckt wird. Die Photolackschicht wird selektiv belichtet und geöffnet, woraufhin selektive Bereiche der CVD-Schicht 16 mittels standardmäßiger Photolithographieverfahren entfernt werden. Die selektiv geätzte CVD-Schicht 16 dient sodann als Maske für den selektiven Ätzvorgang der Polysiliciumschicht 14. Um zu gewährleisten, daß das Polysilicium-Material 14 aus den jeweils gewünschten Bereichen des Gateoxids 12 vollständig entfernt wird, muß man in Kauf nehmen, daß der Ätzvorgang auch die Seitenflächen der Polysiliciumschicht 14 angreift, so daß die CVD-Schicht 16 auf diese Weise einen Überhang bildet. Zwar wird dieser Überhang während eines Redoxydationsschrittes der Polysiliciumschicht 14, wodurch die thermische Oxidschicht 17 gebildet wird, teilweise verringert, gewöhnlich bleibt aber ein durchaus nennenswerter Rest von Überhang bestehen, so daß eine anschließend aufgebrachte Polysiliciumschicht 18, die in Fig. 1 gezeigte und weitgehend unregelmäßige Topologie bzw. Formgebung aufweist. Eine darartige Struktur ist dabei nicht nur anfällig hinsichtlich dielektrischer Probleme zwischen den Polysiliciumschichten 14 und 18, es ist darüber hinaus vielmehr ohnehin schwierig, eine solche Schicht 18 zu erzielen. Die dadurch begründeten Gefahren hinsichtlich von Unterbrechungen und Unregelmäßigkeiten in der Schicht 18 können sowohl Schwierigkeiten bei den anschließenden Verfahrensschritten als auch Folgeprobleme hinsichtlich der fertiggestellten Bauelemente verursachen.

Fig. 2 zeigt eine sich im Rahmen des vorgeschlagenen Herstellungsverfahren ergebende Zwischenstruktur mit einem, vorzugsweise aus einkristallinem Silicium bestehenden Substrat 10, das mit einer thermisch gebildeten Siliciumdioxyd- bzw. Gate-Oxidschicht 20 bedeckt ist. Die Gate-Oxidschicht 20 ist wiederum mit einer Polysiliciumschicht 30 bedeckt, die ihrerseits eine Schicht 40 aus Phosphorsilikatglas (PSG) trägt. Darin liegt eine Abweichung von dem bisherigen Stand der Technik, wonach nämlich die Schicht 40 üblicherweise aus Siliciumdioxyd bestehen würde, das durch chemische Zersetzung aus der Dampfphase (CVD) gebildet würde. Mittels konventioneller photolithographischer Verfahren wird die Schicht 40 selektiv geätzt und dient dann ihrerseits als Maske für das selektive Ätzen der Polysiliciumschicht 30. Bekanntlich muß das Polysilicium 30 vollständig bis hinunter auf die Oberfläche des Gateoxids 20 geätzt werden. Mit fortschreitendem Ätzvorgang wird aber auch ein Teil der Seitenflächen des Polysiliciums 30 durch das Ätzmittel abgetragen, so daß sich daraus resultierend die Unterschneidung bzw. Unterätzung hinsichtlich des Polysiliciums 30 bzw. der Überhang hinsichtlich der PSG-Schicht 40 ergibt.

Um nun einen derartigen Überhang wesentlich zu reduzieren und möglichst sogar vollständig zu beseitigen, wird die in Fig. 2 gezeigte Struktur einem Wärmebehandlungsschritt unterworfen, der quasi ein "Zuruckschnappen" der PSG-Schicht 40 bewirkt. Fig. 3 illustriert, daß dadurch die Überhangbildung praktisch eliminiert werden kann. Ein weiterer Vorteil dieser Wärme- bzw. Fließbehandlung der PSG-Schicht besteht in der weitgehenden Beseitigung von sog. Nadellöchern bzw. Poren. Schließlich ist gegebenenfalls von Vorteil, in der PSG-Schicht vorhandenes überschüssiges Phosphor zur einen N Leitungstyp verursachenden Dotierung des Polysiliciums 30 einzusetzen. Zur Erzielung von nahezu Leiterzugseigenschaften wird das Polysilicium 30 mittels Phosphor bis zu einer Verunreinigungskonzentration in der Größenordnung von $10^{20}/cm^3$ dotiert. Selbst wenn das Polysilicium 30 zuvor mittels üblicher Verfahren bereits dotiert worden ist, verstärken die zusätzlichen N dotierenden Phosphor-Verunreinigungen aus der PSG-Quellschicht die Leitfähigkeitseigenschaften noch weiter. Die genaue Form der fließbehandelten PSG-Schicht 40' bezogen auf die darunterliegende Formgebung der Polysiliciumstruktur 30 wird abhängig sein vom anfänglichen Ausmaß des Überhangs, der Dicke der ursprünglich aufgebrachten PSG-Schicht 40 sowie von der Temperatur und Zeit des Wärmebehandlungsschrittes. Demzufolge stellt die in Fig. 3 gezeigte Anordnung eine beispielhafte Formgebung dar, bei der die Schichtbereiche 40' bei gleichen Volumen wie vor der Fließbehandlung nunmehr eine geringere laterale Ausdehnung aufweisen, so daß der Überhang im wesentlichen beseitigt ist.

In der jetzt erreichten Verfahrensstufe müssen die Seitenflächen der Polysiliciumbereiche 30 gegen einen Kontakt mit anschließend aufzubringenden Leiterzügen isoliert werden. Dazu kann konventionell, wie in Fig. 4 gezeigt ist, eine thermische Oxydation der Seitenflächen des Polysiliciums 30 erfolgen, wodurch die Atome der Polysiliciumschicht unter Bildung der mit 50 bezeichneten Isolierschicht zu Siliciumdioxyd reagieren. Während die Sauerstoffatome das Polysilicium 30 zu Siliciumdioxyd 50 oxydieren, tritt eine Materialausdehnung auf, die einen noch etwa verbliebenen Überhang entsprechend Fig. 3 nunmehr endgültig beseitigt. Während dieser thermischen Oxydation der Seitenflächen des Polysiliciums 30 dringen Sauerstoffatome ebenfalls durch das Gate-Oxid 20 und oxydieren jeweilige Bereiche des darunterliegenden Siliciumsubstrat, so daß dort die in Fig. 4 mit 22 bezeichneten etwas dickeren Gateoxidbereiche entstehen.

Im Anschluß an die Oxydation der Seitenfläche des Polysiliciums kann die so erhaltenen Struktur mit einer durchgehenden zweiten Schicht aus leitendem Polysilicium 60 bedeckt werden, das entweder während oder nach seinem Niederschlag zur Erzielung der entsprechenden Leitfähigkeit dotiert werden kann. Es ist üblich, das Polysilicium 60 in einer durchgehenden, d.h. nicht selektiven Schicht aufzubringen und mit einer weiteren Isolierschicht 70 abzudecken, die ihrerseits eine Photolackschicht trägt. Die mit 70 bezeichnete Isolierschicht besteht entweder aus chemisch aus der Dampfphase niedergeschlagenem Oxid oder aus einer zusammengesetzten Schicht enthaltend eine erste dünne thermische Oxidschicht und eine darüberliegende CVD-Schicht. Die Isolierschicht 70 wird selektiv unter Benutzung konventioneller Photolithographieverfahrensschritte geätzt und dann ihrerseits als Maske für die selektive Entfernung der nicht gewünschten Bereiche in der weiteren Polysiliciumschicht 60 benutzt.

Wie aus Fig. 3 anschaulich wird, verbessert dieses Phänomen des "Zurückschnappens" der PSG-Schicht während der Wärmebehandlung nicht nur die formmäßige Ausbildung des Bauelements, sondern beseitigt darüber hinaus auch evtl. Nadellöcher und verstärkt die Dicke der oberen Isolierung 40'. Zusätzlich wirkt das PSG 40' als Diffusionsquelle, so daß die Polysiliciumschicht 30 aus der PSG-Schicht 40' heraus dotiert werden kann, wodurch die ansonsten zur Dotierung des Polysiliciums 30 im Rahmen des Verfahrensablaufes vorzusehende Behandlung entfallen kann.

Zur möglichst präzisen Steuerung der Dicke und des Dotierungsgrades der PSG-Schicht 40 (Fig. 2) wird diese vorzugsweise durch chemischen Niederschlag aus der Dampfphase hergestellt. In einer Atmosphäre enthaltend ungefähr 2% Sauerstoff ($O_2$), 300 ppm Silan ($SiH_4$) und 30 bis 60 ppm Phosphin ($PH_3$) kann in einem Trägergas aus Stickstoff ($N_2$) bei ungefähr 450°C ein PSG-Überzug jeder gewünschten Dicke gebildet werden. Im Rahmen der vorliegenden Erfindung ist eine Dicke von etwa 0,3 $\mu$m geeignet.

Im Anschluß an den Niederschlag der PSG-Schicht 40 in Fig. 2 erfolgt ein Wärme- bzw. Aufheizschritt, um die entsprechend mit 40' in Fig. 3 bezeichnete Form der PSG-Schicht zu erreichen. Dieser Wärmeschritt wird in einer Stickstoffatmosphäre bei etwa 1000°C für die Dauer ungefähr einer Stunde durchgeführt. Die resultierende Dicke der Schicht 40' wird sich dabei gegenüber der nicht fließbehandelten Schicht 40 in Fig. 2 um etwa 30% vergrößern, wobei jedoch die laterale Ausdehnung des PSG-Überhangs dadurch wesentlich verringert wird. Da während dieses Wärmeschrittes Phosphor aus der PSG-Schicht in das Polysilicium wandert, erfolgt so eine Dotierung des Polysiliciums 30. Die fließbehandelte PSG-Schicht resuliert somit in einer verbesserten Isolation hinsichtlich der Deckflächen des Polysiliciums, und zwar nicht nur wegen der erhöhten Dicke dieser Schicht sondern n auch deshalb, weil durch den Wärmeschritt eventuell vorhandene Nadellöcher in dieser Schicht quasi versiegelt werden. Das in dieser Erfindung ausgenutzte Phänomen des "Zurückschnappens" der PSG-Schicht kann zudem auch im Rahmen anderer Verfahrensabläufe für die Herstellung von Halbleiterstrukturen Anwendung finden, bei denen sog. selbstjustierte Isolierschichten auf einer Unterlage erforderlich sind. Ebenso sind abweichend von dem konkreten beschriebenen Ausführungsbeispiel zahlreiche Abweichungen möglich, z.B. derart, daß der Wärmeschritt zur Erzeugung der in Fig. 3 dargestellten Struktur in einer anderen Inertgasatmosphäre, z.B. enthaltend Argon, Helium bzw. selbst in Vakuum durchgeführt werden kann. Gegebenenfalls könnte selbst eine Sauerstoffatmosphäre vorgesehen werden, wenn eine gleichzeitige Oxydation des Polysiliciums erwünscht ist.

## Patentansprüche

1. Verfahren zur Herstellung von Halbleiteranordnungen mit auf einer Unterlage vorgesehenen Bereichen (30) aus polykristallinem Silicium, bei dem man zunächst auf der Unterlage eine Schicht aus polykristallinem Silicium aufbringt, darüber eine Schicht (40) aus einem Isoliermaterial ausbildet, in der unter Anwendung von Photolithographie- und Ätzverfahren ein vorbestimmtes Muster in Form von Öffnungen erzeugt wird, woran sich unter Einsatz der so strukturierten Schicht (40) aus Isoliermaterial als Maskierungsschicht eine Ätzbehandlung zur Ausbildung eines mit dem vorbestimmten Muster im wesentlichen übereinstimmenden Musters in der darunter befindlichen Schicht (30) aus polykristallinem Silicium anschließt, dadurch gekennzeichnet, daß die Schicht (40) aus Phosphorsilikatglas (PSG) gebildet wird und daß eine zusätzliche und derart ausgestaltete Wärmebehandlung der insoweit gebildeten Schichtstruktur (Fig. 2) durchgeführt wird, daß durch Unterätzung der Schicht (40) aus Phosphorsilikatglas hervorgerufene Überhänge dieser Schicht auf den Deckflächen der Bereiche (30) aus polykristallinem Silicium infolge entsprechender Kontraktion der Schicht (40—40') aus Phosphorsilikatglas weitgehend beseitigt werden (Fig. 3).

2. Verfahren nach Anspruch 1, dadurch gekennzeichnet, daß das Aufbringen der Schicht (40) aus Phosphorsilikatglas bei einer Temperatur von etwa 450°C erfolgt.

3. Verfahren nach Anspruch 1 oder 2, dadurch gekennzeichnet, daß die zusätzliche Wärmebehandlung für etwa eine Stunde bei einer Temperatur von ungefähr 1000°C in einer Stickstoffatmosphäre vorgenommen wird.

4. Verfahren nach einem der Ansprüche 1 bis 3, dadurch gekennzeichnet, daß auf wenigstens einigen Seitenflächen der Bereiche (30) aus polykristallinem Silicium eine Schicht (50) aus Siliciumdioxyd gebildet wird.

5. Verfahren nach Anspruch 4, dadurch gekennzeichnet, daß über die insoweit gebildete Schichtstruktur eine weitere Schicht (60) aus polykristallinem Silicium aufgebracht wird, die zunächst als durchgehende Schicht gebildet und anschließend in an sich bekannter Weise formgeätzt wird.

6. Verfahren nach einem der Ansprüche 1 bis 5, dadurch gekennzeichnet, daß zur Dotierung der Bereiche (30) aus polykristallinem Silicium die zusätzliche Wärmebehandlung sowie als Quellschicht die Schicht (40) aus Phosphorsilikatglas benutzt wird.

7. Verfahren nach einem der vorhergehenden Ansprüche, insbesondere nach Anspruch 4, dadurch gekennzeichnet, daß die auf den Seitenflächen der Bereiche (30) aus polykristallinem Silicium gebildete Schicht (50) aus Siliciumdioxyd in einer jeglichen Restüberhang der Deckflächenbeschichtung (40') ausgleichenden Dicke gebildet wird.

8. Halbleiteranordnung mit gegenüber einer Unterlage (10) sowie gegeneinander isolierten Bereichen (30) aus polykristallinem Silicium sowie einer darüber angeordneten Schicht aus Phosphorsilikatglas (PSG), hergestellt nach einem Verfahren der in den vorhergehenden Ansprüchen bezeichneten Art, dadurch gekennzeichnet, daß die Schicht (40') aus Phosphorsilikatglas jeweils nur die Deckflächen der Bereiche (30) aus polykristallinem Silicium bedeckt und aus einer in einem zusätzlichen Wärmeprozeß fließbehandelten Phosphorsilikatglasschicht besteht, die im wesentlichen die gleiche laterale Ausdehnung wie die Oberfläche der Bereiche (30) aus polykristallinem Silicium aufweist.

9. Halbleiteranordnung nach Anspruch 8, dadurch gekennzeichnet, daß die nicht von der Schicht (40') aus Phosphorsilikatglas bedeckten Flächen der Bereiche (30) aus polykristallinem Silicium mit einer Schicht (50) aus thermischem Oxid bedeckt sind.

**Revendications**

1. Procédé pour fabriquer des dispositifs semi-conducteurs comportant des régions (30) de silicium polycristallin sur un support, dans lequel on dépose d'abord sur le support une couche de silicium polycristallin, et on forme au-dessus de celle-ci une couche (40) d'un matériau isolant dans laquelle on forme une configuration prédéterminée d'ouvertures en utilisant des procédés de photolithographie et de décapage, ces procédés étant suivis par un décapage pour former, dans la couche sous-jacente (30) de silicium polycristallin, une configuration qui correspond essentiellement à la configuration prédéterminée, en utilisant, comme couche de masquage, la couche (40) ainsi structurée d'un matériau isolant, procédé caractérisé en ce que la couche (40) est composée de verre de silicate de phosphore (PSG), et en ce qu'on soumet la structure de couche ainsi formée (figure 2) à un traitement thermique supplémentaire de telle sorte que des surplombs de cette couche dûs au décapage· latéral de la couche (40) de verre de silicate de phosphore soient, dans une large mesure, éliminés, des surfaces des régions (30) de silicium polycristallin par contraction de la couche (40—40') de verre de silicate de phosphore (figure 3).

2. Procédé selon la revendication 1, caractérisé en ce qu'on dépose la couche (40) de verre de silicate de phosphore à une température d'environ 450°C.

3. Procédé selon la revendication 1 ou 2, caractérisé en ce qu'on effectue le traitement thermique supplémentaire pendant environ 1 heure à une température d'environ 1000°C dans une atmosphère d'azote.

4. Procédé selon l'une quelconque des revendications 1 à 3, caractérisé en ce qu'on forme, au moins sur quelquesunes des surfaces latérales des régions (30) en silicium polycristallin, une couche (50) de dioxyde de silicium.

5. Procédé selon la revendication 4, caractérisé en ce qu'on dépose sur la structure de couches ainsi formée une autre couche (60) de silicium polycristallin qui forme d'abord une couche recouvrant tout et qui est ensuite décapée de la façon connue, pour obtenir la configuration désirée.

6. Procédé selon l'une quelconque des revendications 1 à 5, caractérisé en ce qu'on utilise pour le dopage des régions (30) en silicium polycristallin le traitement thermique supplémentaire et la couche (40) de verre de silicate de phosphore comme couche de source.

7. Procédé selon l'une quelconque des revendications précédentes, en particulier selon la revendication 4, caractérisé en ce que la couche (50) de dioxyde de silicium formée sur les surfaces latérales des régions (30) en silicium polycristallin a une épaisseur qui compense un surplomb éventuel restant du dépôt de surface (40').

8. Dispositif semi-conducteur comportant des régions (30) en silicium polycristallin, isolées les unes des autres et d'un support (10), et une couche superposée de verre de silicate de phosphore (PSG), fabriqué selon un procédé du type mentionné dans les revendications précédentes, caractérisé en ce que la couche (40') de verre de silicate de phosphore ne recouvre que les surfaces supérieures des régions (30) en silicium polycristallin et est composée d'une couche de verre de silicate de phosphore soumis à la contraction dans un traitement thermique supplémentaire, cette couche ayant essentiellement la même extension latérale que la surface des régions (30) en silicium polycristallin.

9. Dispositif semi-conducteur selon la revendication 8, caractérisé en ce qu'on dépose une couche (50) d'oxyde thermique sur les surfaces des régions (30) en silicium polycristallin, non recouvertes de la couche (40') de verre de silicate de phosphore.

## Claims

1. Process for producing semiconductor devices with areas (30) of polycrystalline silicon provided on a substrate, wherein, initially, a layer of polycrystalline silicon is deposited on the substrate, this layer being followed by a layer (40) of an insulating material, in which, using photolithography and etching, a predetermined pattern of openings is formed, and wherein, subsequently, utilizing the layer (40) of insulating material thus structured as a masking layer, etching is effected to form a pattern substantially like the predetermined pattern in the underlying layer (30) of polycrystalline silicon, characterized in that the layer (40) is made of phosphosilicate glass (PSG), and that the layer structure (Fig. 2) thus obtained is additionally heat treated in such a manner that overhangs of this layer on the top surfaces of the areas (30) of polycristalline silicon, which are caused by undercutting layer (40) are largely eliminated by contraction of layer (40—40') of phosphosilicate glass (Fig. 3).

2. Process according to claim 1, characterized in that layer (40) of phosphosilicate glass is deposited at a temperature of about 450°C.

3. Process according to claim 1 or 2, characterized in that the additional heat treatment takes place at a temperature of about 1000°C in a nitrogen atmosphere for about 1 hour.

4. Process according to any one of the claims 1 to 3, characterized in that a layer (50) of silicon dioxide is formed on at least some of the sidewall portions of the areas (30).

5. Process according to claim 4, characterized in that the structure thus obtained is covered with a further layer (60) of polycrystalline silicon which is initially deposited as a blanket layer that is subsequently etched to shape in a known manner.

6. Process according to any one of the claims 1 to 5, characterized in that areas (30) of polycrystalline silicon are doped by being additionally heat-treated, with layer (40) of phosphosilicate glass acting as a source layer.

7. Process according to any one of the preceding claims, in particular claim 4, characterized in that layer (50) of silicon dioxide covering the sidewall portions of areas (30) of polycrystalline silicon has a thickness compensating for any residual overhang of the top surface layer (40').

8. Semiconductor structure with areas (30) isolated from substrate (10) and from each other, as well as an overlying layer of phosphosilicate glass (PSG), produced by a process of the kind specified in the preceding claims, characterized in that layer (40') of phosphosilicate glass covers only the top surfaces of the areas (30) of polycrystalline silicon and consists of an additionally heat-treated contractable phosphosilicate glass layer which is substantially coextensive with the surfaces of the areas (30) of polycrystalline silicon.

9. Semiconductor structure according to claim 8, characterized in that the surfaces of the areas (30) of polycrystalline silicon not covered by the layer (40') of phosphosilicate glass are covered with a layer (50) of thermal oxide.

## FIG. 1

## FIG. 2

## FIG. 3

## FIG. 4